# EUROPEAN PATENT SPECIFICATION

(11) **EP 2 368 212 B1**
(45) Date of publication and mention of the grant of the patent: **19.08.2015**
(21) Application number: 09801875.7
(22) Date of filing: 17.12.2009
(51) Int. Cl.: G06K 7/10, H01S 5/068

(54) **METHOD AND APPARATUS FOR CONTROLLING AND MONITORING LASER POWER IN BARCODE READERS**
VERFAHREN UND VORRICHTUNG ZUR STEUERUNG UND ÜBERWACHUNG DER LASERLEISTUNG BEI STRICHCODELESERN
PROCÉDÉ ET APPAREIL DE COMMANDE ET DE SURVEILLANCE DE PUISSANCE LASER DANS DES LECTEURS DE CODE À BARRES

(30) Priority: 18.12.2008 US 337865
(43) Date of publication of application: 28.09.2011
(73) Proprietor: Symbol Technologies, Inc., Holtsville, NY 11742-1300 (US)
(72) Inventor: GIEBEL, James, Centerport New York 11721 (US)
(74) Representative: Kopf, Korbinian Paul
(86) International application number: PCT/US2009/068354
(87) International publication number: WO 2010/080456

(56) References cited:
- WO-A2-2007/040877
- US-A1- 2005 073 268
- US-A1- 2007 098 027

## Description

### FIELD OF THE DISCLOSURE

The present invention relates generally to barcode readers.

### BACKGROUND

Various electro-optical systems or readers have been developed for reading indicia such as bar code symbols appearing on a label or on a surface of an article. The bar code symbol itself is a coded pattern of graphic indicia comprised of a series of bars of various widths spaced apart from one another to bound spaces of various widths, the bars and spaces having different light reflecting characteristics. The readers function by electro-optically transforming the pattern of the graphic indicia into a time-varying electrical signal, which is digitized and decoded into data relating to the symbol being read.

Typically, a laser beam from a laser is directed along a light path toward a target that includes the bar code symbol on a target surface. A moving-beam scanner operates by repetitively sweeping the laser beam in a scan line or a series of scan lines across the symbol by means of motion of a scanning component, such as the laser itself or a scan mirror disposed in the path of the laser beam. Optics focus the laser beam into a beam spot on the target surface, and the motion of the scanning component sweeps the beam spot across the symbol to trace a scan line across the symbol. Motion of the scanning component is typically effected by an electrical drive motor.

The readers also include a sensor or photodetector which detects light along the scan line that is reflected or scattered from the symbol. The photodetector or sensor is positioned such that it has a field of view which ensures the capture of the reflected or scattered light, and converts the latter into an electrical analog signal

In retroreflective light collection, a single optical component, e.g., a reciprocally oscillatory mirror sweeps the beam across the target surface and directs the collected light to the sensor. In non-retroreflective light collection, the reflected laser light is not collected by the same optical component used for scanning. Instead, the sensor is independent of the scanning beam and has a large field of view. The reflected laser light may trace across the sensor.

Electronic control circuitry and software decode the electrical analog signal from the sensor into a digital representation of the data represented by the symbol that has been scanned. For example, the analog electrical signal generated by the photodetector may be converted by a digitizer into a pulse width modulated digitized signal, with the widths corresponding to the physical widths of the bars and spaces. Alternatively, the analog electrical signal may be processed directly by a software decoder.

The decoding process usually works by applying the digitized signal to a microprocessor running a software algorithm, which attempts to decode the signal. If a symbol is decoded successfully and completely, the decoding terminates, and an indicator of a successful read (such as a green light and/or audible beep) is provided to a user. Otherwise, the microprocessor receives the next scan, and performs another decoding into a binary representation of the data encoded in the symbol, and to the alphanumeric characters so represented. Once a successful read is obtained, the binary data is communicated to a host computer for further processing, for example, information retrieval from a look-up table.

Although reading performance is enhanced when the output power of the laser is increased, government regulatory safety standards dictate the maximum power output of the laser for human safety. Some of these standards require that the output power of the laser does not exceed regulatory limits even when control circuitry that normally regulates the laser output power fails. This requires a redundant system to monitor the laser.

For example, a monitor photodiode inside the laser housing is normally operative for monitoring the raw laser output power. The monitor photodiode is part of a feedback circuit for maintaining the laser output power constant during operation. If the monitor photodiode were to lose sensitivity, fail, or to become electrically disconnected from the feedback circuit, then the feedback signal would increase or be lost, and the feedback circuit would increase the laser output power, possibly to a level exceeding regulatory limits.

Another example involves a drive transistor electrically connected in series with the laser and normally operative to generate a drive current to energize the laser. If the drive transistor were to fail, then the laser output power might increase to levels exceeding regulatory limits.

Laser readers typically sweep the laser beam with a motor drive, and a motor fail circuit is provided to deenergize the laser if the motor drive is not operational. After the motor fail circuit deenergizes the laser, an operator wondering what is wrong with the reader might stare inside a window of the reader while pulling the trigger despite printed caution labels stating "Do not stare into laser beam" If the motor drive restarts, there is no problem with staring at the moving beam. However, if the motor drive does not restart, then the output power for the stationary laser beam now being emitted from the reader will not meet regulatory standards.

Accordingly, there is a need for a method and apparatus for monitoring the power output of the laser.

US 2005/0073268 describes a drive device for a light-emitting component including a reference source.

### SUMMARY

In one aspect, the invention is directed to a method of monitoring the output power of a laser diode in a barcode reader. The method includes sampling a threshold monitoring-current that is related to the driving-current passing through the laser diode during a first time period when this current is at the lasing threshold of the laser diode. The method includes holding the threshold monitoring-current during a second time period. The method includes generating an above-threshold monitoring-current during at least part of the second time period when the driving-current passing through the laser diode is above the threshold of the laser diode. The method includes generating a threshold-compensated monitoring-current by subtracting the threshold monitoring-current from the above-threshold monitoring-current. The method includes monitoring the output power of the laser diode in the barcode reader at least partially based on the threshold-compensated monitoring-current.

### BRIEF DESCRIPTION OF THE FIGURES

The accompanying figures, where like reference numerals refer to identical or functionally similar elements throughout the separate views, together with the detailed description below, are incorporated in and form part of the specification, and serve to further illustrate embodiments of concepts that include the claimed invention, and explain various principles and advantages of those embodiments.
FIG. 1 is a perspective view of an electro-optical reader in accordance with the prior art.
FIG. 2 is a part-diagrammatic, circuit schematic depicting one embodiment of a laser power control arrangement in accordance with the present invention especially useful in the reader of FIG. 1.
FIG. 3 is a graph depicting raw laser power operation of the circuit of FIG. 2 during a calibration mode.
FIG. 4 is a graph analogous to FIG. 3, but during an operating mode.
FIG. 5 shows an electronic circuit in accordance with some embodiments that can monitor the current passing through the laser diode compensated by the threshold current of the laser diode.
FIG. 6 is a timing diagram showing the driving-current of the laser diode and the threshold-compensated monitoring-current as a function of time in accordance with some embodiments.
FIG. 7 shows in general a method 100 of monitoring the output power of a laser diode in a barcode reader in accordance with some embodiments.

Skilled artisans will appreciate that elements in the figures are illustrated for simplicity and clarity and have not necessarily been drawn to scale. For example, the dimensions of some of the elements in the figures may be exaggerated relative to other elements to help to improve understanding of embodiments of the present invention.

The apparatus and method components have been represented where appropriate by conventional symbols in the drawings, showing only those specific details that are pertinent to understanding the embodiments of the present invention so as not to obscure the disclosure with details that will be readily apparent to those of ordinary skill in the art having the benefit of the description herein.

### DETAILED DESCRIPTION

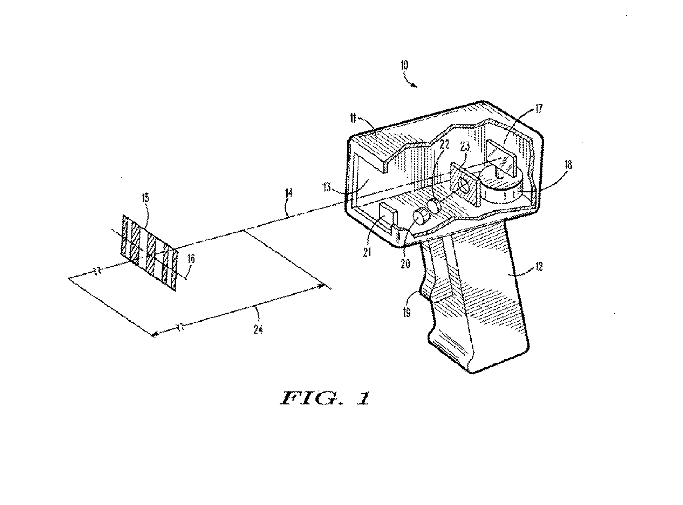

As used herein, the term "symbol" broadly encompasses not only symbol patterns composed of alternating bars and spaces of various widths as commonly referred to as bar code symbols, but also other one- or two-dimensional graphic patterns, as well as alphanumeric characters. In general, the term "symbol" may apply to any type of pattern or indicia which may be recognized or identified either by scanning a light beam and detecting reflected or scattered light as a representation of variations in light reflectivity at various points of the pattern or indicia. FIG. 1 shows an indicium 15 as one example of a "symbol" to be read.

FIG. 1 depicts a handheld laser scanner device 10 for reading symbols. The laser scanner device 10 includes a housing having a barrel portion 11 and a handle 12. Although the drawing depicts a handheld pistol-shaped housing, the invention may also be implemented in other types of housings such as a desk-top workstation or a stationary scanner. In the illustrated embodiment, the barrel portion 11 of the housing includes an exit port or window 13 through which an outgoing laser light beam 14 passes to impinge on, and scan across, the bar code symbol 15 located at some distance from the housing.

The laser beam 14 moves across the symbol 15 to create a scan pattern. Typically, the scanning pattern is one-dimensional or linear, as shown by line 16. This linear scanning movement of the laser beam 14 is generated by an oscillating scan mirror 17 driven by an oscillating motor drive 18. If desired, means may be provided to scan the beam 14 through a two-dimensional scanning pattern, to permit reading of two-dimensional optically encoded symbols. A manually-actuated trigger 19 or similar means permit an operator to initiate the scanning operation when the operator holds and aims the device 10 at the symbol 15.

The scanner device 10 includes an energizable laser source 20 mounted within the housing. The laser source 20 generates the laser beam 14. A photodetector 21 is positioned within the housing to collect at least a portion of the light reflected and scattered from the bar code symbol 15. The photodetector 21, as shown, faces toward the window 13 and has a static, wide field of view characteristic of the non-retro-reflective readers described above. Alternatively, in a retro-reflective reader, a convex portion of the scan mirror 17 may focus collected light on the photodetector 21, in which case the photodetector faces toward the scan mirror. As the beam 14 sweeps the symbol 15, the photodetector 21 detects the light reflected and scattered from the symbol 15 and creates an analog electrical signal proportional to the intensity of the collected light.

A digitizer (not shown) typically converts the analog signal into a pulse width modulated digital signal, with the pulse widths and/or spacings corresponding to the physical widths of the bars and spaces of the scanned symbol 15. A decoder (not shown), typically comprising a programmed microprocessor with associated RAM and ROM, decodes the pulse width modulated digital signal according to the specific symbology to derive a binary representation of the data encoded in the symbol, and the alphanumeric characters represented by the symbol.

The laser source 20 directs the laser beam through an optical assembly comprising a focusing lens 22 and an aperture stop 23, to modify and direct the laser beam onto the scan mirror 17. The mirror 17, mounted on a vertical shaft and oscillated by the motor drive 18 about a vertical axis, reflects the beam and directs it through the exit port 13 to the symbol 15.

To operate the scanner device 10, the operator depresses trigger 19 which activates the laser source 20 and the motor drive 18. The laser source 20 generates the laser beam which passes through the element 22 and aperture 23 combination. The element 22 and aperture 23 modify the beam to create an intense beam spot of a given size which extends continuously and does not vary substantially over a range 24 of working distances. The element and aperture combination directs the beam onto the rotary mirror 17, which directs the modified laser beam outwardly from the scanner housing 11 and toward the bar code symbol 15 in a sweeping pattern, i.e., along scan line 16. The bar code symbol 15, placed at any point within the working distance 24 and substantially normal to the laser beam 14, reflects and scatters a portion of the laser light. The photodetector 21, shown mounted in the scanner housing 11 in a non-retro-reflective position, detects the reflected and scattered light and converts the received light into an analog electrical signal. The photodetector could also be mounted in a retro-reflective position facing the scan mirror 17. The system circuitry then converts the analog signal to a pulse width modulated digital signal which a microprocessor-based decoder decodes according to the characteristics of the bar code symbology rules.

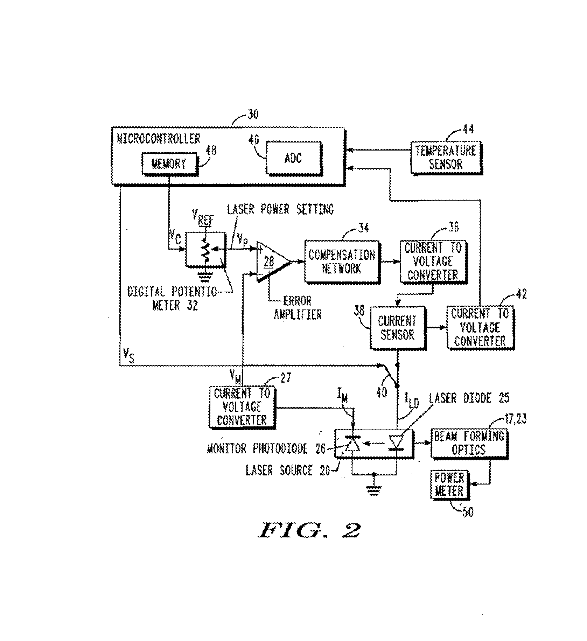

As shown in FIG. 2, the laser source 20 includes a laser diode 25 and a monitor photodiode 26 within the laser source. The monitor photodiode 26 is operative for monitoring the raw output power of the diode 25. The photodiode 26 is part of a feedback circuit operative for maintaining the laser output power constant. The feedback circuit includes a current to voltage converter 27 for converting the monitor drive current I_{M} flowing through the monitor photodiode 26 to a monitor drive voltage V_{M} which, in turn, is connected to a negative terminal of an error amplifier 28. A microcontroller 30, preferably the same one used to decode the symbol, generates, as described below, respective digital control signals V_{C} to set a digital potentiometer 32 to respective potentiometer settings. An output signal V_{P} from the potentiometer is conducted to a positive terminal of the error amplifier 28, and an output of the error amplifier is conducted to a compensation network 34 whose output voltage is converted to a current by a voltage to current converter 36 which, in turn, is connected to a current sensor 38.

The current flowing through the current sensor 38 is conducted through a normally closed power switch 40 to the laser diode 25 to energize the same with a drive current I_{LD} to emit the laser beam 14 with an output power. The current flowing through the current sensor 38 is also preferably reduced in amplitude by flowing through a divider and is converted by a current to voltage converter 42 to a voltage which is fed back to the microprocessor 30 via an analog to digital converter (ADC) 46.

A temperature sensor 44 is also connected to the ADC 46 to apprise the microcontroller of the temperature. Also, the microprocessor is associated with a memory 48 in which data is stored.

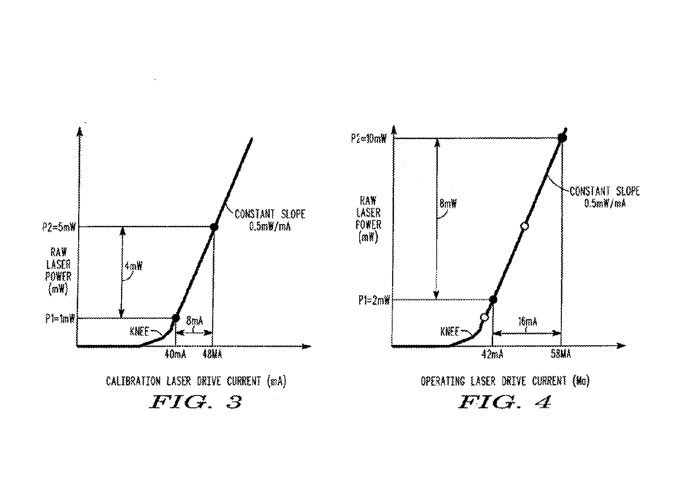

As described so far, the interior monitor photodiode 26 detects changes in raw output power of the laser beam emitted by laser diode 25 and sends a feedback signal to the error amplifier 28 to allow more or less drive current to pass through the laser diode 25. The greater this drive current, the greater the laser output power, and vice versa, as explained below in connection with FIGS. 3-4.

If the monitor photodiode 26 loses its sensitivity, or fails, or becomes electrically disconnected, or for any change in the feedback circuit, then the laser output power will increase. Regulatory safety limits can still be obtained by a laser power control arrangement which, in accordance with this invention, monitors the output power of the laser diode 25 and deenergizes the latter when an over-power condition is detected.

The transfer function of a laser in which the raw output power of the emitted laser beam is plotted against the drive current flowing through the laser is depicted in FIGS. 3-4. FIG. 3 depicts a numerical example of powers and currents that can be encountered during a calibration mode, whereas FIG. 4 depicts a numerical example of powers and currents that can be encountered during an operating mode. In order for a laser to emit coherent light, a drive current must be pumped through the laser at the threshold of lasing operation, commonly referred to as the "knee" of the transfer function. Once this threshold is exceeded, additional drive current produces output powers that are directly, or nearly linearly proportional, to the drive current. The laser of the instant invention is operated in this linear region of the transfer function. The slope of this linear region is assumed to be substantially constant but does slightly vary with variations in temperature or with aging. For example, this linear region may change by about 20% as the temperature varies over extremes, e.g., from -30° C. to +65° C.

The change in slope as a function of temperature can be stored in the memory of the microcontroller. Thus, during the operating mode, the temperature sensor 44 apprises the microcontroller of the current temperature and, in turn, the microcontroller corrects the transfer function as a function of the detected temperature.

During the calibration mode, that is after manufacture of the reader and during an initial powering up of the reader, the output power of the emitted laser beam is measured and monitored, preferably by a power meter 50 downstream of beam forming optics 17, 23, and the microcontroller 40 adjusts the potentiometer 32 so that the output power of the laser beam measures a first output power, which is known to be within regulatory limits, for example, 1 milliwatt. The current sensor 38 measures the corresponding drive current, for example, 40 milliamps, to produce the output power of 1 milliwatt. This measured drive current is stored in the memory 48, as is the potentiometer setting P1 needed to produce the output power of 1 milliwatt.

During the same calibration mode, the microcontroller 40 again adjusts the potentiometer so that the laser beam output power measures a second output power, also known to be within regulatory limits, for example, 5 milliwatts. As before, the current sensor 38 measures the corresponding drive current, for example, 48 mA, and this measured drive current, together with the new potentiometer setting P2, are stored in the memory 48.

The microcontroller 30 then calculates the difference between the calibration drive currents (48-40 mA=8 mA), and stores this calibration difference in the memory. The microcontroller now knows that it takes 8 mA to change the output power by 4 mW (5 mW-1 mW). The slope of this linear region is 0.5 mW/mA.

During a subsequent operating mode, for example, during reading of the indicia, the microcontroller 30 executes a similar routine. The microcontroller sets the potentiometer 32 at the first potentiometer setting P1, and the current sensor measures the corresponding drive current. Then, the microcontroller sets the potentiometer 32 at the second potentiometer setting P2, and the current sensor measures the corresponding drive current.

Assuming, for the sake of explanation, that the monitor photodiode 26 sensitivity is cut in half, then the corresponding output powers for the laser beam are doubled. Thus, the output power at the first potentiometer setting P1 will be 2 mW, and the output power at the second potentiometer setting P2 will be 10 mW. In order for the slope of the linear region of the transfer function to be constant, then the corresponding operating drive currents are 42 mA and 58 mA for the first and second potentiometer settings, respectively.

The microcontroller then calculates the difference between the operating drive currents (58 mA-42 mA=16 mA), and stores this operating difference in the memory. The microcontroller then compares the operating difference (16 mA) with the calibration difference (8 mA). Since the operating difference is two times greater than the calibration difference, the microcontroller now knows that the output power has doubled. The microcontroller generates a switch signal VS operative to open the normally closed power switch 40, thereby deenergizing the laser and preferably notifying a remote host that the laser is failing or has failed.

By comparing drive current differences, any effects caused by temperature variations or other variables are substantially reduced, if not eliminated. Thus, if a certain temperature affects the power and the drive current at one potentiometer setting, then it will correspondingly affect the power and the drive current at the other potentiometer setting. By subtracting the drive current differences, such variations are removed.

In FIG. 2, when both the laser diode 25 and the monitor photodiode 26 function properly, the current I_{LD} passing through the laser diode 25 can be set by a voltage Vₚ at an input terminal of the error amplifier 28, and the current I_{LD} can be monitored by the current sensor 38. In addition to the electronic circuit as shown in FIG. 2, there are other electronic circuits that can perform the function of setting the current I_{LD} with a voltage and the function of monitoring the current I_{LD} passing through the laser diode 25. In some of the applications in which the current I_{LD} need to be monitored, it may be preferable to subtract the threshold current Iₜₕ of the laser diode 25 from the current I_{LD} to improve accuracy in the measurement.

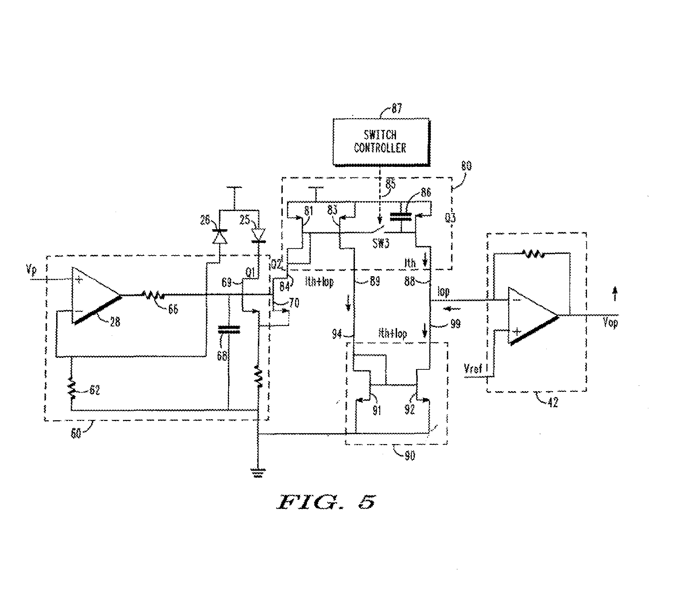

FIG. 5 shows an electronic circuit in accordance with some embodiments that can monitor the current passing through the laser diode compensated by the threshold current of the laser diode. In FIG. 5, a programmable-current-source 60 includes a feedback loop for generating the driving-current I_{LD} passing through the laser diode 25. The feedback loop includes a photo-detector 26 for sampling light emitted from the laser diode 25. The programmable-current-source 60 also includes an amplifier 28. The amplifier 28 has a first input for receiving a setting voltage Vₚ and a second input that receives a voltage proportional to the photocurrent from the photo-detector 26. In FIG. 5, a small portion of light from the laser diode 25 is coupled to the photo-detector 26 and generates some photocurrent. The photocurrent generated from the photo-detector 26 passes though a resistor 62 and generates a voltage at the second input of the amplifier 28. The voltage at the output of the amplifier 28 is coupled to the gate of a FET 69 for generating the driving-current I_{LD} passing through the laser diode 25. The voltage at the output of the amplifier 28 generally is coupled to the gate of a FET 69 though a compensation network. In the specific example in FIG.5, the compensation network includes a resistor 66 and a capacitor 68.

In FIG 5, the driving-current I_{LD} passing through the laser diode 25 is sampled by a current-sampling device 70 that outputs a monitoring-current that is directly related to the driving-current with a predetermine relationship. In one implementation, the current-sampling device 70 includes a transistor having a gate subject to the same bias voltage as the gate of the transistor 69 in the programmable-current-source 60. When the channel width of the transistor 70 is related to the channel width of the transistor 69 with a predetermined proportional constant, the monitoring-current generated in the channel of the transistor 70 can be proportional to the driving-current I_{LD} passing through the laser diode 25. In one specific implementation, when the transistor 69 and the transistor 70 are substantially identical, the monitoring-current generated in the channel of the transistor 70 will be substantially equal to the driving-current I_{LD} passing through the laser diode 25.

In FIG. 5, with the assistance of a first current mirror device 80 and a second current mirror device 90, it is possible to convert an uncompensated monitoring-current into a threshold-compensated monitoring-current, where the threshold-compensated monitoring-current is proportional to (or otherwise related to) the difference between the current I_{LD} passing through the laser diode 25 and the threshold current Iₜₕ of the laser diode 25.

In FIG. 5, the first current mirror device 80 has an input 84, a first output 88, and a second output 89. The first current mirror device 80 includes a first transistor 81, a second transistor 82, a third transistor 83, a storage capacitive element 86, and a liner switch 85 that has an external control input connected to a switch controller 87. The first transistor 81 has a semiconductor channel with a terminal as the input 84 of the first current mirror device, and this terminal is also connected a gate of the first transistor 81. The second transistor 82 has a semiconductor channel with a terminal as the first output 88 of the first current mirror device 90. The gate of the second transistor 82 is connected to the gate of the first transistor 81 through the linear switch 85. The third transistor 83 has a semiconductor channel with a terminal as the second output 89 of the first current mirror device 80. The gate of the third transistor 83 is connected to the gate of the first transistor 81. The storage capacitive element 86 is connected to the gate of the second transistor 82.

The input 84 of the first current mirror device 80 receives the monitoring-current from the current-sampling device 70. When the first current mirror device 80 is in a sampling-mode, the liner switch 85 is closed (i.e., which is conducting) to enable the storage capacitive element 86 be charged by the voltage at the gate of the first transistor 81. In the sampling-mode, the first output 88 of the first current mirror device 80 outputs a current mirroring the monitoring-current in the semiconductor channel of the of the first transistor 81. When the first current mirror device 80 is in a holding-mode, the liner switch 85 is opened (i.e., which is non-conducting) to maintain the voltage across the storage capacitive element 86. In the holding-mode, the monitoring-current at the instant when the liner switch 85 is opened can be maintained as a memorized current, and this memorized current will be the current at the first output 88 of the first current mirror device 80.

In FIG. 5, the second current mirror device 90 has an input 94 and an output 99. The second current mirror device 90 includes a first transistor 91 and a second transistor 92. The first transistor 91 has a semiconductor channel with a terminal as the input 94 of the second current mirror device 90. The first transistor 91 has a gate connected to the terminal at the input 94. The second transistor 92 has a semiconductor channel with a terminal as the output 99 of the second current mirror device 90. The second transistor 92 also has a gate connected to the gate of the first transistor 91. The input 94 of the second current mirror device 90 receives the current from the second output 89 of the first current mirror device 80. The output 99 of the second current mirror device 90 generates a current mirroring the current received from the second output 89 of the first current mirror device 80.

In FIG. 5, the output 99 of the second current mirror device 90 is connected with the first output 88 of the first current mirror device 80. The current at the output 99 generated by the second current mirror device 90 is subtracted from the current at the first output 88 generated by the first current mirror device 80 and the resulting current difference is coupled to the current-to-voltage converter 42. The voltage Vₒₚ at the output of the current-to-voltage converter 42 is linearly depending upon the current difference at its input. In FIG. 5, the current-to-voltage converter 42 also receives a reference voltage V_{ref}, and voltage Vₒₚ at the output of the current-to-voltage converter 42 is maintained at an offset voltage V_{ref} when it receives zero current input.

In operation, during a first time period, a voltage Vₜₕ is set at the input of the programmable-current-source 60 to drive the laser diode 25 with a driving-current I_{LD}=Iₜₕ at the threshold of the laser diode 25. With a specific implementation in which the transistor 69 and the transistor 70 are substantially identical, the monitoring-current generated in the channel of the transistor 70 will be a threshold monitoring-current Iₜₕ that is equal to the driving-current I_{LD} at the threshold of the laser diode 25. During the first time period, the first current mirror device 80 is set at the sampling-mode and the liner switch 85 is closed (i.e., which is conducting). In the sampling-mode, the first output 88 of the first current mirror device 80 outputs a current Iₜₕ mirroring the threshold monitoring-current Iₜₕ received at the input 84. The voltage across the storage capacitive element 86 also changes with the threshold monitoring-current Iₜₕ received at the input 84. At the end of the first time period, the first current mirror device 80 is changed to the holding-mode and the liner switch 85 is opened (i.e., which is non-conducting). As soon as the first current mirror device 80 is changed to the holding-mode, the voltage across the storage capacitive element 86 will be maintained. Consequently, the monitoring-current at the first output 88 will be maintained at a value equal to the threshold monitoring-current Iₜₕ, which is equal to the driving-current I_{LD} at the threshold of the laser diode 25.

After the first current mirror device 80 is changed to the holding-mode, it will be kept in the holding-mode for a second time period. During the second time period, a voltage Vₗₒₚ is set at the input of the programmable-current-source 60 to drive the laser diode 25 with a driving-current I_{LD} = Iₒₚ+ Iₜₕ, which is higher than the threshold current Iₜₕ of the laser diode 25. With a specific implementation in which the transistor 69 and the transistor 70 are substantially identical, the monitoring-current generated in the channel of the transistor 70 will be an above-threshold monitoring-current that is equal to the driving-current I_{LD} = Iₒₚ+ Iₜₕ passing though the laser diode 25. In the holding-mode, the above-threshold monitoring-current current Iₒₚ+ Iₜₕ in the semiconductor channel of the transistor 81 is mirrored to the second output 89 of the first current mirror device 80. The input 94 of the second current mirror device 90 receives the current Iₒₚ+ Iₜₕ from the second output 89 of the first current mirror device 80. The output 99 of the second current mirror device 90 generates a current Iₒₚ+ Iₜₕ mirroring the current received from the second output 89 of the first current mirror device 80. The current Iₒₚ+ Iₜₕ at the output 99 of the second current mirror device 90 is subtracted from the threshold monitoring-current Iₜₕ at the first output 88 of the first current mirror device 80 to generate a threshold-compensated monitoring-current Iₒₚ. The threshold-compensated monitoring-current Iₒₚ is converted into a monitoring voltage Vₒₚ by the current-to-voltage converter 42.

In FIG. 5, the monitoring voltage Vₒₚ subtracting the offset voltage V_{ref} is proportional to the threshold-compensated monitoring-current Iₒₚ. With the offset voltage V_{ref} and the gain of the current-to-voltage converter 42 properly selected, the monitoring voltage Vₒₚ may measure the driving-current I_{LD} of the laser diode 25 more accurately over a larger dynamic range than certain electronic circuits that measure the driving-current I_{LD} directly without subtracting the threshold current Iₜₕ.

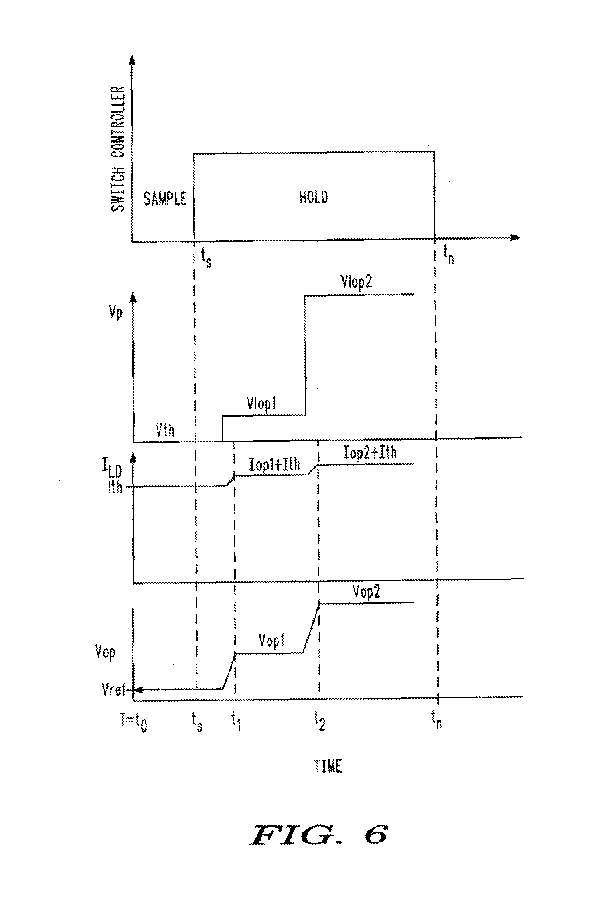

FIG. 6 is a timing diagram showing the driving-current of the laser diode and the threshold-compensated monitoring-current as a function of time in accordance with some embodiments. In FIG. 6, the threshold-compensated monitoring-current Iₒₚ is represented by the monitoring voltage Vₒₚ at the output of the current-to-voltage converter 42. In a first time period from time to to time tₛ, the input voltage Vₚ of the programmable-current-source 60 is set at voltage Vₜₕ (i.e., Vₚ=Vₜₕ) to cause the driving-current be set at the threshold of the laser diode 25 (i.e., I_{LD}=Iₜₕ). During this first time period, the first current mirror device 80 is set at the sampling-mode by the switch controller 87, and the monitoring voltage Vₒₚ is equal to the offset voltage V_{ref} (i.e., Vₒₚ=V_{ref}).

At time tₛ, the first current mirror device 80 is changed to the holding-mode. Thereafter, the first current mirror device 80 is maintained at the holding-mode during a second time period from time tₛ to time tₕ. During this second time period, the monitoring voltage Vₒₚ subtracting the offset voltage V_{ref} is proportional to the threshold-compensated monitoring-current Iₒₚ. During a time period that is somewhat before time t₁, the input voltage Vₚ is still set at the voltage Vₜₕ (i.e., Vₚ=Vₜₕ), the driving-current is still set at the threshold of the laser diode (i.e., I_{LD}=Iₜₕ), the threshold-compensated monitoring-current Iₒₚ is zero (i.e., Iₒₚ=0), and the monitoring voltage Vₒₚ is equal to the offset voltage V_{ref} (i.e., Vₒₚ= V_{ref}).

At time t₁, the input voltage Vₚ is set at a voltage Vₗₒₚ₁ (i.e., Vₚ=Vₗₒₚ₁), the driving-current I_{LD} is above the threshold of the laser diode by an amount of Iₒₚ₁ (i.e., I_{LD}=Iₜₕ+ Iₒₚ₁) and the monitoring voltage Vₒₚ₁ subtracting the offset voltage V_{ref} is proportional to the threshold-compensated monitoring-current Iₒₚ₁. Similarly, at time t₂, the input voltage Vₚ is set at a voltage Vₗₒₚ₂ (i.e., Vₚ=Vₗₒₚ₂), the driving-current I_{LD} is above the threshold of the laser diode by an amount of Iₒₚ₂ (i.e., I_{LD}=Iₜₕ+ Iₒₚ₂) and the monitoring voltage Vₒₚ₂ subtracting the offset voltage V_{ref} is proportional to the threshold-compensated monitoring-current Iₒₚ₂.

In a sample implementation as described previously, the transistor 69 and the transistor 70 are substantially identical, and the monitoring-current generated in the channel of the transistor 70 is substantially equal to the driving-current I_{LD} passing through the laser diode 25. In many other implementations, the transistor 69 and the transistor 70 can be designed to have substantially different channel width. In some designs, the monitoring-current generated in the channel of the transistor 70 can be proportional to the driving-current I_{LD} passing through the laser diode 25 with a predetermined proportional constant. For example, the monitoring-current can be 1% of the driving-current I_{LD} passing through the laser diode 25.

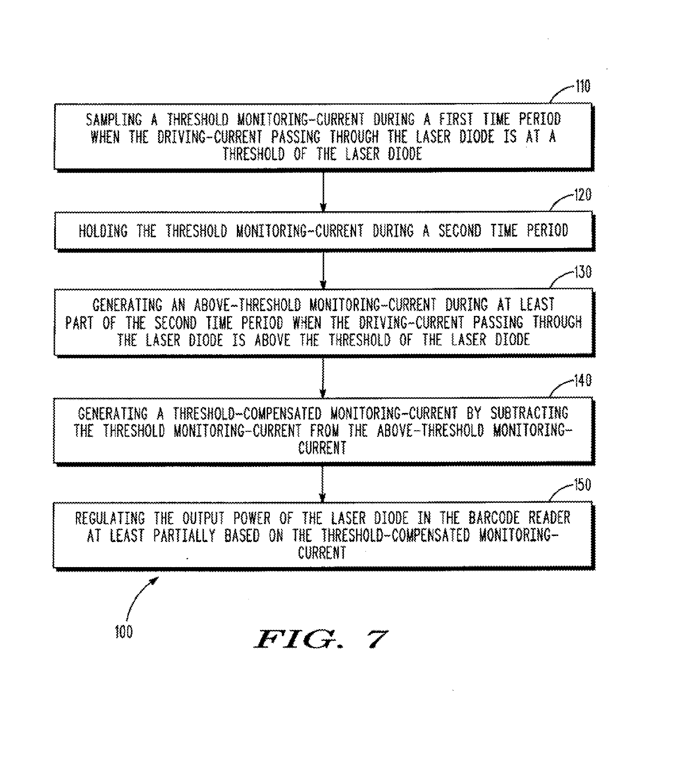

FIG. 7 shows in general a method 100 of monitoring the output power of a laser diode in a barcode reader in accordance with some embodiments. The method 100 includes blocks 110, 120, 130, 140, 150. At block 110, a threshold monitoring-current is sampled during a first time period when the driving-current passing through the laser diode is at a threshold of the laser diode. At block 120, the threshold monitoring-current is hold at a constant value during a second time period. At block 130, an above-threshold monitoring-current is generated during at least part of the second time period when the driving-current passing through the laser diode is above the threshold of the laser diode. At block 140, a threshold-compensated monitoring-current is generated by subtracting the threshold monitoring-current from the above-threshold monitoring-current. At block 150, the threshold-compensated monitoring-current is used at least partially to monitor the output power of the laser diode in the barcode reader.

The block 150 can be implemented to fit several particular uses. For example, in the embodiment as shown FIG. 5, the threshold-compensated monitoring-current can be measured for each input voltage Vₚ selected from a list of the input voltages of the programmable-current-source 60 during a calibration stage to generate a lookup table. The threshold-compensated monitoring-current can be measured for a given input voltage Vₚ of the programmable-current-source 60 during normal operation. The measured threshold-compensated monitoring-current can be used to detect possible malfunctions of the laser diode systems in barcode readers. The measured threshold-compensated monitoring-current can also be used to control the driving-current of the laser diode more precisely in another feedback loop. More specifically, the measured threshold-compensated monitoring-current can be compared with an expectation value, and the current deviated from the expectation value can be used as an error signal for correcting the input voltage of the programmable-current-source 60. Generally, the threshold-compensated monitoring-current can be used at least partially to monitor the output power of the laser diode in laser scanning barcode readers or the laser diode in the aiming system of imagining barcode readers.

In the foregoing specification, specific embodiments have been described. However, one of ordinary skill in the art appreciates that various modifications and changes can be made without departing from the scope of the invention as set forth in the claims below. Accordingly, the specification and figures are to be regarded in an illustrative rather than a restrictive sense.

The benefits, advantages, solutions to problems, and any element(s) that may cause any benefit, advantage, or solution to occur or become more pronounced are not to be construed as a critical, required, or essential features or elements of any or all the claims. The invention is defined solely by the appended claims including any amendments made during the pendency of this application and all equivalents of those claims as issued.

Moreover in this document, relational terms such as first and second, top and bottom, and the like may be used solely to distinguish one entity or action from another entity or action without necessarily requiring or implying any actual such relationship or order between such entities or actions. The terms "comprises," "comprising," "has", "having," "includes", "including," "contains", "containing" or any other variation thereof, are intended to cover a non-exclusive inclusion, such that a process, method, article, or apparatus that comprises, has, includes, contains a list of elements does not include only those elements but may include other elements not expressly listed or inherent to such process, method, article, or apparatus. An element proceeded by "comprises ... a", "has ... a", "includes ... a", "contains ... a" does not, without more constraints, preclude the existence of additional identical elements in the process, method, article, or apparatus that comprises, has, includes, contains the element. The terms "a" and "an" are defined as one or more unless explicitly stated otherwise herein. The terms "substantially", "essentially", "approximately", "about" or any other version thereof, are defined as being close to as understood by one of ordinary skill in the art, and in one non-limiting embodiment the term is defined to be within 10%, in another embodiment within 5%, in another embodiment within 1% and in another embodiment within 0.5%. The term "coupled" as used herein is defined as connected, although not necessarily directly and not necessarily mechanically. A device or structure that is "configured" in a certain way is configured in at least that way, but may also be configured in ways that are not listed.

It will be appreciated that some embodiments may be comprised of one or more generic or specialized processors (or "processing devices") such as microprocessors, digital signal processors, customized processors and field programmable gate arrays (FPGAs) and unique stored program instructions (including both software and firmware) that control the one or more processors to implement, in conjunction with certain non-processor circuits, some, most, or all of the functions of the method and/or apparatus described herein. Alternatively, some or all functions could be implemented by a state machine that has no stored program instructions, or in one or more application specific integrated circuits (ASICs), in which each function or some combinations of certain of the functions are implemented as custom logic. Of course, a combination of the two approaches could be used.

Moreover, an embodiment can be implemented as a computer-readable storage medium having computer readable code stored thereon for programming a computer (e.g., comprising a processor) to perform a method as described and claimed herein. Examples of such computer-readable storage mediums include, but are not limited to, a hard disk, a CD-ROM, an optical storage device, a magnetic storage device, a ROM (Read Only Memory), a PROM (Programmable Read Only Memory), an EPROM (Erasable Programmable Read Only Memory), an EEPROM (Electrically Erasable Programmable Read Only Memory) and a Flash memory. Further, it is expected that one of ordinary skill, notwithstanding possibly significant effort and many design choices motivated by, for example, available time, current technology, and economic considerations, when guided by the concepts and principles disclosed herein will be readily capable of generating such software instructions and programs and ICs with minimal experimentation.

The Abstract of the Disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A method of monitoring the output power of a laser diode (25) in a barcode reader comprising:
sampling (110) a threshold monitoring-current that is related to the driving-current passing through the laser diode (25) during a first time period when the driving-current passing through the laser diode is at a threshold of the laser diode;
holding (120) the threshold monitoring-current during a second time period;
generating (130) an above-threshold monitoring-current during at least part of the second time period when the driving-current passing through the laser diode is above the threshold of the laser diode;
generating (140) a threshold-compensated monitoring-current by subtracting the threshold monitoring-current from the above-threshold monitoring-current; and
monitoring the output power of the laser diode in the barcode reader at least partially based on the threshold-compensated monitoring-current.

2. The method of claim 1, further comprising:
generating with a current-sampling device (70) a monitoring-current that is directly related to the driving-current with a predetermine relationship; and
coupling an input (84) of a first current mirror device (80) with an output of the current-sampling device (70).

3. The method of claim 2, wherein:
the monitoring-current is proportional to the driving current with a predetermined proportional constant.

4. The method of claim 2, wherein:
the sampling a threshold monitoring-current comprises sampling a threshold monitoring-current by sampling a voltage on a storage capacitive element (86) in a first current mirror device (80) when the driving-current passing through the laser diode (25) is at the threshold of the laser diode; and
the holding the threshold monitoring-current comprises holding the threshold monitoring-current generated at a first output (88) of the first current mirror device (80) by holding a voltage on the storage capacitive element (86) in the first current mirror device (80).

5. The method of claim 4, wherein
the generating an above-threshold monitoring-current comprises generating an above-threshold monitoring-current at an output (99) of a second current mirror device (90) when the driving-current passing through the laser diode (25) is above the threshold of the laser diode (25), wherein the second current mirror device (90) has an input receiving the above-threshold monitoring-current from a second output (89) of the first current mirror device (80); and
the generating a threshold-compensated monitoring-current comprises generating a threshold-compensated monitoring-current by subtracting the threshold monitoring-current generated at the first output (88) of the first current mirror device (80) from the above-threshold monitoring-current at the output of the second current mirror device (90).

6. The method of claim 1, further comprising:
outputting the threshold-compensated monitoring-current to a current-to-voltage converter (42).

7. The method of claim 1, wherein the driving-current is generated with a programmable-current-source (60) having a transistor for outputting the driving-current, and wherein:
the current-sampling device (60) comprises a transistor having a gate subject to the same bias voltage as the gate of the transistor (69) in the programmable-current-source (60).

8. The method of claim 1, further comprising:
generating driving-current passing through the laser diode (25) with a programmable-current-source (60) having a feedback loop including a photo-detector (26) for sampling light emitted from the laser diode (25).

9. A device for monitoring a driving-current passing through a laser diode (25) in a barcode reader comprises:
a current-sampling device (70) operative to sample the driving-current passing through the laser diode (25) in the barcode reader and operative to output a monitoring-current that is directly related to the driving-current with a predetermine relationship;
a first current mirror device (80) having an input (84) receiving the monitoring-current from the current-sampling device (70), the first current mirror device (80) having a first output (88) that outputs a current mirroring the monitoring-current when the first current mirror device (80) is in a sampling-mode and maintaining a memorized current when the first current mirror device (80) is in a holding-mode, and the first current mirror device (80) having a second output (89) that outputs a current mirroring the monitoring-current; and
a second current mirror device (90) having an input (94) receiving the current from the second output (89) of the first current mirror device (80), the second current mirror device (90) having an output (99) that outputs a current mirroring the current received from the second output (89) of the first current mirror device (80).

10. The device of claim 9, wherein:
the monitoring-current is proportional to the driving current with a predetermined proportional constant.

11. The device of claim 9, wherein:
the output of the second current mirror device (90) is connected to the first output (88) of the first current mirror device (80).

12. The device of claim 9, further comprising:
a current-to-voltage converter (42) having an input connecting to the first output (88) of the first current mirror device (80); and
wherein the output of the second current mirror device (90) is connected to the first output (88) of the first current mirror device (80).

13. The device of claim 9, further comprising:
a programmable-current-source (60) having a feedback loop for generating driving-current passing through the laser diode, the feedback loop having a photo-detector (26) for sampling light emitted from the laser diode (25).

14. The device of claim 13, wherein:
the programmable-current-source (60) comprises an amplifier (28) having a first input receiving a setting voltage and a second input for receiving a voltage proportional to the photocurrent from the photo-detector (26) that samples light emitted from the laser diode (25).

15. The device of claim 13, the programmable-current-source (60) having a transistor for outputting the driving-current passing through the laser diode (25), wherein:
the current-sampling device (70) comprises a transistor having a gate subject to the same bias voltage as the gate of the transistor (69) in the programmable-current-source (60).

## Patentansprüche

1. Verfahren zum Überwachen der Ausgangsleistung einer Laserdiode (25) in einem Strichcodeleser, das Folgendes beinhaltet:
Abtasten (110) eines Grenzwertüberwachungsstroms, der sich auf den Ansteuerstrom bezieht, der während einer ersten Periode durch die Laserdiode (25) passiert, wenn der durch die Laserdiode passierende Ansteuerstrom auf einem Grenzwert der Laserdiode ist;
Halten (120) des Grenzwertüberwachungsstroms während einer zweiten Zeitperiode;
Erzeugen (130) eines Über-Grenzwert-Überwachungsstroms während wenigstens eines Teils der zweiten Zeitperiode, wenn der durch die Laserdiode passierende Ansteuerstrom über dem Grenzwert der Laserdiode liegt;
Erzeugen (140) eines grenzwertkompensierten Überwachungsstroms durch Subtrahieren des Grenzwertüberwachungsstroms von dem Über-Grenzwert-Überwachungsstrom; und
Überwachen der Ausgangsleistung der Laserdiode im Strichcodeleser wenigstens teilweise auf der Basis des grenzwertkompensierten Überwachungsstroms.

2. Verfahren nach Anspruch 1, das ferner Folgendes beinhaltet:
Erzeugen, mit einer Stromabtastvorrichtung (70), eines Überwachungsstroms, der mit einer vorbestimmten Beziehung direkt auf den Ansteuerstrom bezogen ist; und
Koppeln eines Eingangs (84) einer ersten Stromspiegelvorrichtung (80) mit einem Ausgang der Stromabtastvorrichtung (70).

3. Verfahren nach Anspruch 2, wobei:
der Überwachungsstrom proportional zum Ansteuerstrom mit einer vorbestimmten Proportionalkonstante ist.

4. Verfahren nach Anspruch 2, wobei:
das Abtasten eines Grenzwertüberwachungsstroms das Abtasten eines Grenzwertüberwachungsstroms durch Abtasten einer Spannung an einem kapazitiven Speicherelement (86) in einer ersten Stromspiegelvorrichtung (80) beinhaltet, wenn der durch die Laserdiode (25) passierende Ansteuerstrom auf dem Grenzwert der Laserdiode ist; und
das Halten des Grenzwertüberwachungsstroms das Halten des an einem ersten Ausgang (88) der ersten Stromspiegelvorrichtung (80) erzeugten Grenzwertüberwachungsstroms durch Halten einer Spannung auf dem kapazitiven Speicherelement (86) in der ersten Stromspiegelvorrichtung (80) beinhaltet.

5. Verfahren nach Anspruch 4, wobei
das Erzeugen eines Über-Grenzwert-Überwachungsstroms das Erzeugen eines Über-Grenzwert-Überwachungsstroms an einem Ausgang (99) einer zweiten Stromspiegelvorrichtung (90) beinhaltet, wenn der durch die Laserdiode (25) passierende Ansteuerstrom über dem Grenzwert der Laserdiode (25) liegt, wobei die zweite Stromspiegelvorrichtung (90) einen Eingang hat, der den Über-Grenzwert-Überwachungsstrom von einem zweiten Ausgang (89) der ersten Stromspiegelvorrichtung (80) erhält; und
das Erzeugen eines grenzwertkompensierten Überwachungsstroms das Erzeugen eines grenzwertkompensierten Überwachungsstroms durch Subtrahieren des am ersten Ausgang (88) der ersten Stromspiegelvorrichtung (80) erzeugten Grenzwertüberwachungsstroms von dem Über-Grenzwert-Überwachungsstrom am Ausgang der zweiten Stromspiegelvorrichtung (80) beinhaltet.

6. Verfahren nach Anspruch 1, das ferner das Ausgeben des grenzwertkompensierten Überwachungsstroms an einen Strom-Spannungs-Wandler (42) beinhaltet.

7. Verfahren nach Anspruch 1, wobei der Ansteuerstrom mit einer programmierbaren Stromquelle (60) mit einem Transistor zum Ausgeben des Ansteuerstroms erzeugt wird, und wobei:
die Stromabtastvorrichtung (60) einen Transistor mit einem Gate umfasst, das derselben Vorspannung unterliegt wie das Gate des Transistors (69) in der programmierbaren Stromquelle (60).

8. Verfahren nach Anspruch 1, das ferner Folgendes beinhaltet:
Erzeugen eines durch die Laserdiode (25) passierenden Ansteuerstroms mit einer programmierbaren Stromquelle (60), die eine Feedback-Schleife mit einem Fotodetektor (26) zum Abtasten von von der Laserdiode (25) emittiertem Licht beinhaltet.

9. Vorrichtung zum Überwachen eines durch eine Laserdiode (25) passierenden Ansteuerstroms in einem Strichcodelaser, die Folgendes umfasst:
eine Stromabtastvorrichtung (70) zum Abtasten des durch die Laserdiode (25) passierenden Ansteuerstroms in dem Strichcodeleser und zum Ausgeben eines Überwachungsstroms, der sich mit einer vorbestimmten Beziehung direkt auf den Ansteuerstrom bezieht;
eine erste Stromspiegelvorrichtung (80) mit einem Eingang (84), der den Überwachungsstrom von der Stromabtastvorrichtung (70) empfängt, wobei die erste Stromspiegelvorrichtung (80) einen ersten Ausgang (88) hat, der einen den Überwachungsstrom spiegelnden Strom ausgibt, wenn die erste Stromspiegelvorrichtung (80) in einem Abtastmodus ist, und einen gespeicherten Strom hält, wenn die erste Stromspiegelvorrichtung (80) in einem Haltemodus ist, und wobei die erste Stromspiegelvorrichtung (80) einen zweiten Ausgang (89) aufweist, der einen den Überwachungsstrom spiegelnden Strom ausgibt; und
eine zweite Stromspiegelvorrichtung (90) mit einem Eingang (94), der den Strom vom zweiten Ausgang (89) der ersten Stromspiegelvorrichtung (80) empfängt, wobei die zweite Stromspiegelvorrichtung (90) einen Ausgang (99) hat, der einen Strom ausgibt, der den vom zweiten Ausgang (89) der ersten Stromspiegelvorrichtung (80) empfangenen Strom spiegelt.

10. Vorrichtung nach Anspruch 9, wobei
der Überwachungsstrom proportional zum Ansteuerstrom mit einer vorbestimmten Proportionalkonstante ist.

11. Vorrichtung nach Anspruch 9, wobei
der Ausgang der zweiten Stromspiegelvorrichtung (90) mit dem ersten Ausgang (88) der ersten Stromspiegelvorrichtung (80) verbunden ist.

12. Vorrichtung nach Anspruch 9, die ferner Folgendes umfasst:
einen Strom-Spannungs-Wandler (42) mit einem Eingang, der mit dem ersten Ausgang (88) der ersten Stromspiegelvorrichtung (80) verbunden ist; und
wobei der Ausgang der zweiten Stromspiegelvorrichtung (90) mit dem ersten Ausgang (88) der ersten Stromspiegelvorrichtung (80) verbunden ist.

13. Vorrichtung nach Anspruch 9, die ferner Folgendes umfasst:
eine programmierbare Stromquelle (60) mit einer Feedback-Schleife zum Erzeugen von durch die Laserdiode passierendem Ansteuerstrom, wobei die Feedback-Schleife einen Fotodetektor (26) zum Abtasten von von der Laserdiode (25) emittiertem Licht aufweist.

14. Vorrichtung nach Anspruch 13, wobei:
die programmierbare Stromquelle (60) einen Verstärker (28) mit einem ersten Eingang zum Empfangen einer Einstellspannung und einem zweiten Eingang zum Empfangen einer Spannung proportional zum Fotostrom von dem Fotodetektor (26) umfasst, der von der Laserdiode (25) emittiertes Licht abtastet.

15. Vorrichtung nach Anspruch 13, wobei die programmierbare Stromquelle (60) einen Transistor zum Ausgeben des durch die Laserdiode (25) passierenden Ansteuerstroms hat, wobei:
die Stromabtastvorrichtung (70) einen Transistor mit einem Gate umfasst, der derselben Vorspannung unterliegt wie das Gate des Transistors (69) in der programmierbaren Stromquelle (60).

## Revendications

1. Procédé de surveillance de la puissance de sortie d'une diode laser (25) dans un lecteur de code à barres comprenant :
l'échantillonnage (110) d'un courant de surveillance de seuil qui est lié au courant de commande passant à travers la diode laser (25) pendant une première période de temps lorsque le courant de commande passant à travers la diode laser est à un seuil de la diode laser ;
le maintien (120) du courant de surveillance de seuil pendant une deuxième période de temps ;
la génération (130) d'un courant de surveillance au-dessus du seuil pendant au moins une partie de la deuxième période de temps lorsque le courant de commande passant à travers la diode laser est au-dessus du seuil de la diode laser ;
la génération (140) d'un courant de surveillance compensé par le courant de seuil en soustrayant le courant de surveillance de seuil du courant de surveillance au-dessus du seuil ; et
la surveillance de la puissance de sortie de la diode laser dans le lecteur de code à barres au moins partiellement sur la base du courant de surveillance compensé par le courant seuil.

2. Procédé selon la revendication 1, comprenant en outre :
la génération, par un dispositif d'échantillonnage de courant (70), d'un courant de surveillance qui est lié directement au courant de commande avec une relation prédéterminée ; et
le couplage d'une entrée (84) d'un premier dispositif miroir de courant (80) à une sortie du dispositif d'échantillonnage de courant (70).

3. Procédé selon la revendication 2, dans lequel :
le courant de surveillance est proportionnel au courant de commande avec une constante de proportionnalité prédéterminée.

4. Procédé selon la revendication 2, dans lequel :
l'échantillonnage d'un courant de surveillance de seuil comprend l'échantillonnage d'un courant de surveillance de seuil en échantillonnant une tension sur un élément capacitif de stockage (86) dans un premier dispositif miroir de courant (80) lorsque le courant de commande passant à travers la diode laser (25) est au seuil de la diode laser ; et
le maintien du courant de surveillance de seuil comprend le maintien du courant de surveillance de seuil généré au niveau d'une première sortie (88) du premier dispositif miroir de courant (80) en maintenant une tension sur l'élément capacitif de stockage (86) dans le premier dispositif miroir de courant (80).

5. Procédé selon la revendication 4, dans lequel
la génération d'un courant de surveillance au-dessus du seuil comprend la génération d'un courant de surveillance au-dessus du seuil au niveau d'une sortie (99) d'un deuxième dispositif miroir de courant (90) lorsque le courant de commande passant à travers la diode laser (25) est au-dessus du seuil de la diode laser (25), dans lequel le deuxième dispositif miroir de courant (90) a une entrée recevant le courant de surveillance au-dessus du seuil d'une deuxième sortie (89) du premier dispositif miroir de courant (80) ; et
la génération d'un courant de surveillance compensé par le courant de seuil comprend la génération d'un courant de surveillance compensé par le courant de seuil en soustrayant le courant de surveillance de seuil généré au niveau de la première sortie (88) du premier dispositif miroir de courant (80) du courant de surveillance au-dessus du seuil au niveau de la sortie du deuxième dispositif miroir de courant (90).

6. Procédé selon la revendication 1, comprenant en outre :
l'application du courant de surveillance compensé par le courant de seuil à un convertisseur courant-tension (42).

7. Procédé selon la revendication 1, dans lequel le courant de commande est généré par une source de courant programmable (60) comportant un transistor pour délivrer le courant de commande, et dans lequel :
le dispositif d'échantillonnage de courant (60) comprend un transistor comportant une grille soumise à la même tension de polarisation que la grille du transistor (69) dans la source de courant programmable (60).

8. Procédé selon la revendication 1, comprenant en outre :
la génération d'un courant de commande passant à travers la diode laser (25) par une source de courant programmable (60) comportant une boucle de rétroaction comprenant un photodétecteur (26) pour échantillonner la lumière émise par la diode laser (25).

9. Dispositif pour surveiller un courant de commande passant à travers une diode laser (25) dans un lecteur de code à barres comprenant :
un dispositif d'échantillonnage de courant (70) pouvant être utilisé pour échantillonner le courant de commande passant à travers la diode laser (25) dans le lecteur de code à barres et pouvant être utilisé pour délivrer un courant de surveillance qui est lié directement au courant de commande avec une relation prédéterminée ;
un premier dispositif miroir de courant (80) comportant une entrée (84) recevant le courant de surveillance du dispositif d'échantillonnage de courant (70), le premier dispositif miroir de courant (80) comportant une première sortie (88) qui délivre un courant miroir du courant de surveillance lorsque le premier dispositif miroir de courant (80) est dans un mode d'échantillonnage et maintenant un courant mémorisé lorsque le premier dispositif miroir de courant (80) est dans un mode de maintien, et le premier dispositif miroir de courant (80) comportant une deuxième sortie (89) qui délivre un courant miroir du courant de surveillance ; et
un deuxième dispositif miroir de courant (90) comportant une entrée (94) recevant le courant de la deuxième sortie (89) du premier dispositif miroir de courant (80), le deuxième dispositif miroir de courant (90) comportant une sortie (99) qui délivre un courant miroir du courant reçu de la deuxième sortie (89) du premier dispositif miroir de courant (80).

10. Dispositif selon la revendication 9, dans lequel :
le courant de surveillance est proportionnel au courant de commande avec une constante de proportionnalité prédéterminée.

11. Dispositif selon la revendication 9, dans lequel :
la sortie du deuxième dispositif miroir de courant (90) est connectée à la première sortie (88) du premier dispositif miroir de courant (80).

12. Dispositif selon la revendication 9, comprenant en outre :
un convertisseur courant-tension (42) comportant une entrée connectée à la première sortie (88) du premier dispositif miroir de courant (80) ; et
dans lequel la sortie du deuxième dispositif miroir de courant (90) est connectée à la première sortie (88) du premier dispositif miroir de courant (80).

13. Dispositif selon la revendication 9, comprenant en outre :
une source de courant programmable (60) comportant une boucle de rétroaction pour générer un courant de commande passant à travers la diode laser, la boucle de rétroaction comportant un photodétecteur (26) pour échantillonner la lumière émise par la diode laser (25).

14. Dispositif selon la revendication 13, dans lequel :
la source de courant programmable (60) comprend un amplificateur (28) comportant une première entrée recevant une tension de réglage et une deuxième entrée pour recevoir une tension proportionnelle au photocourant provenant du photodétecteur (26) qui échantillonne la lumière émise par la diode laser (25).

15. Dispositif selon la revendication 13, dans lequel la source de courant programmable (60) comporte un transistor pour délivrer le courant de commande passant à travers la diode laser (25), dans lequel :
le dispositif d'échantillonnage de courant (70) comprend un transistor comportant une grille soumise à la même tension de polarisation que la grille du transistor (69) dans la source de courant programmable (60).
